# EUROPEAN PATENT SPECIFICATION

(11) **EP 4 149 226 B1**
(45) Date of publication and mention of the grant of the patent: **02.10.2024**
(21) Application number: 21821334.6
(22) Date of filing: 11.06.2021
(51) Int. Cl.: C09K 5/14, H05K 7/20, C04B 35/583

(54) **HEAT DISSIPATION SHEET**
WÄRMEABLEITUNGSFOLIE
FEUILLE DE DISSIPATION DE CHALEUR

(30) Priority: 12.06.2020 JP 2020102303
(43) Date of publication of application: 15.03.2023
(73) Proprietor: Denka Company Limited, Tokyo 103-8338 (JP)
(72) Inventor: WADA, Kosuke, Tokyo 103-8338 (JP); FUJI, Kiyotaka, Tokyo 103-8338 (JP); TANIGUCHI, Yoshitaka, Tokyo 103-8338 (JP)
(74) Representative: Gulde & Partner
(86) International application number: PCT/JP2021/022361
(87) International publication number: WO 2021/251495

(56) References cited:
- EP-A1- 3 647 265
- EP-A1- 3 761 355
- WO-A1-2014/199650
- WO-A1-2018/123788
- WO-A1-2019/065150
- WO-A1-2019/164002
- JP-A- 2005 343 983
- JP-A- 2015 021 025
- US-B1- 10 308 856

## Description

### Technical Field

The present invention relates to a heat dissipation sheet prepared by molding a thermally conductive resin composition.

### Background Art

With respect to heat-generating electronic parts such as a power device, a transistor, a thyristor, and a CPU, an important issue is how to effectively dissipate heat which generates on operating. As the measures for the heat dissipation, the following measures (1) and (2) have been generally employed.
(1) the insulating layer of a printed wiring board on which the heat-generating electronic part is mounted is made to have a high thermal conductance.
(2) a heat-generating electronic part or a printed wiring board on which the heat-generating electronic part is mounted is attached to a heat sink through an electrically insulating thermal interface material. As the insulating layer of the printed wiring board and the thermal interface material, a silicone resin or an epoxy resin each filled with ceramic powder is used.

In recent years, with high speed and high integration of the circuit included in the heat-generating electronic part and an increase in the mounting density of the heat-generating electronic part on a printed circuit board, the heat generation density inside the electronic equipment increases year by year. Therefore, ceramic powder having a higher thermal conductivity than ever is being demanded (for example, see PTL 1). For example, PTL2 discloses a hexagonal boron nitride (h-BN) powder which is used as a filler of an insulating heat dissipation material of a resin, wherein the h-BN powder comprises aggregates of primary particles of h-BN and boron as an impurity element at a content of 1.00 to 30.00% by mass and oxygen as an impurity element at a content of 0 to 1.00% by mass, which has a peak A in a predetermined particle diameter range and a 50% volume cumulative particle diameter D50 (dl) of 30.0 to 200.0 µm in a particle size distribution curve. PTL 3 describes an insulating heat dissipation sheet, comprising hexagonal boron nitride and a silicone resin, wherein the particle size frequency distribution of the hexagonal boron nitride has maximal peaks in a range of 35 to 100 µm, and in a range of 10 to 25 µm and/or in a range of 0.4 to 5 µm; the average particle size of the hexagonal boron nitride is in a range of 30 to 80 µm; and the insulating heat dissipation sheet comprises a silicone composition containing the hexagonal boron nitride in a content of 40 to 70% by volume and the silicone resin in a content of 30 to 60% by volume. PTL4 relates to an hBN powder containing an aggregate of primary particles of hBN, the hBN powder having a ratio of an average longer diameter (L₁) to an average thickness (d₁) of the primary particles, [L₁/d₁], of 10 to 25, in which a particle size distribution curve showing a frequency distribution based on volume of the hBN powder is a bimodal distribution curve having a first peak and a second peak in a range of a particle size of 500 µm or less and having a peak height ratio of a second peak height (H_{B}) to a first peak height (H_{A}), [(H_{B})/(H_{A})], of 0.90 or less.

### Citation List

### Patent Literature

PTL 1: JP 9-202663 A
PTL 2 : EP 3 647 265 Al
PTL 3 : WO 2019/164002 A1
PTL 4 : WO 201 8/1 23788 A1

### Summary of Invention

### Technical Problem

In recent years, with the miniaturization of heat-generating electronic parts, a thin heat dissipation sheet is demanded. Incidentally, a doctor blade method is known as a method of continuously obtaining a thin molded article composed of powder of a ceramic raw material and an organic matter component. The doctor blade method is a method of thinly spreading a homogeneous slurry on a carrier film to obtain a molded article. The doctor blade method is used widely for a ceramic board for electronic equipment, a ceramic package for IC, a multi-layer ceramic package, a multi-layer ceramic circuit board, a ceramic capacitor, and the like. From the point of view of mass-producing a thin heat dissipation sheet, the thin heat dissipation sheet is also preferably produced according to the doctor blade method. According to the doctor blade method, a sheet-shaped molded article is prepared by making a slurry flow out of a clearance between a blade and a carrier film to form a sheet-shaped molded article. With the dimension between the blade and the carrier film being reduced, a thin molded article can be obtained. However, in the case of using a slurry prepared by using ceramic powder, which is included in the heat dissipation sheet having the conventional thickness, it is difficult to prepare a thin heat dissipation sheet retaining the thermal conductivity to a high level by reducing the dimension between the blade and the carrier film.

Accordingly, an object of the present invention is to provide a thin heat dissipation sheet having excellent thermal conductance.

### Solution to Problem

The present inventors have studied assiduously to achieve the object, and have found that by using inorganic fillers having the respective specific particle sizes in combination and filling the inorganic fillers until the surface roughness falls within a prescribed range, a heat dissipation sheet having a thickness of 0.2 mm or less, further 0.15 mm or less, while exhibiting a favorite thermal conductance, can be provided.

The present invention is based on the above-described recognition and provides the following aspects.
[1] A heat dissipation sheet,
   which is prepared by molding a thermally conductive resin composition prepared by blending an inorganic filler component and a resin component, the inorganic filler component including a first inorganic filler and a second inorganic filler,
   provided that a particle size distribution of the inorganic filler component includes a first maximum point attributable to the first inorganic filler and a second maximum point attributable to the second inorganic filler, the particle size at the first maximum point is 15 pm or more; the particle size at the second maximum point is 30% or more and 2/3 or less the particle size at the first maximum point; and an accumulated amount of the frequency between the peak start and the peak end of the peak having the first maximum point is 70% or more, an accumulated amount of the frequency between the peak start and the peak end of the peak having the second maximum point is 25% or more, and
   which has a surface roughness of 1.5 to 3.0 pm and a thickness of 0.2 mm or less.
[2] The heat dissipation sheet according to the above [1],
   wherein, with respect to the particle size accumulation of the inorganic filler component, the accumulated amount of the frequency at the particle size of from 0 to 15 µm is less than 60%.
[3] The heat dissipation sheet according to the above [1] or [2], further including a base material having a thickness of 0.05 mm or less.

### Advantageous Effects of Invention

According to the present invention, a thin heat dissipation sheet having excellent thermal conductance can be provided.

### Brief Description of Drawings

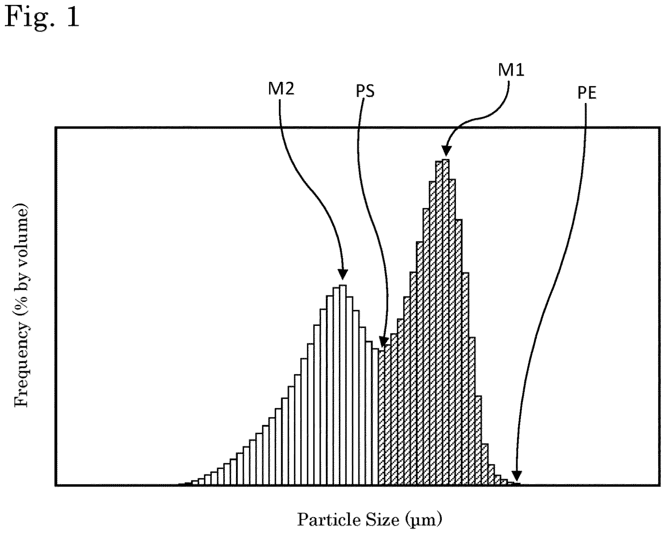

Fig. 1 shows an example of a particle size distribution of an inorganic filler component.

### Description of Embodiments

The heat dissipation sheet of the present invention is one prepared by molding a thermally conductive resin composition in which an inorganic filler component and a resin component are blended.

### [Thermally Conductive Resin Composition]

The thermally conductive resin composition of the present invention is one prepared by blending an inorganic filler component and a resin component.

### (Inorganic Filler Component)

The inorganic filler component includes a first inorganic filler and a second inorganic filler, and the particle size distribution of the inorganic filler component includes a first maximum point attributable to the first inorganic filler and a second maximum point attributable to the second inorganic filler. The particle size at the first maximum point is 15 pm or more, and the particle size at the second maximum point is 2/3 or less the particle size at the first maximum point. The accumulated amount of the frequency between the peak start and the peak end of the peak having the first maximum point is 50% or more.

The particle size distribution of the inorganic filler component included in the thermally conductive resin composition can be measured as follows, for example. The other components than the inorganic filler component included in the thermally conductive composition are removed by dissolving out the other components than the inorganic filler component included in the thermally conductive composition with a solvent such as toluene, xylene, or a chlorine-based hydrocarbon. Then, the particle size distribution of the remaining inorganic filler component is measured by a laser diffraction/scattering particle size distribution measuring apparatus (LS-13 320) manufactured by Beckman Coulter. Incidentally, in the case where three or more peaks are present, the peak which is highest with respect to the frequency at the maximum point is regarded as a peak having a maximum point attributable to the first inorganic filler, and the peak which is the next highest with respect to the frequency at the maximum point is regarded as a peak having a maximum point attributable to the second inorganic filler. Please note that the unit of the frequency in the particle size distribution is % by volume in this description.

### <First Inorganic Filler>

The first inorganic filler is not limited particularly as long as it is an inorganic filler whose thermal conductivity is higher than that of the resin component. For the first inorganic filler, for example, aluminum particle, aluminum nitride particle, boron nitride particle and the like are exemplified. One of these first inorganic fillers may be used singly, or two or more thereof may be used in combination. Among them, the first inorganic filler is preferably a boron nitride particle. In the case where the first inorganic filler is a boron nitride particle, the thermal conductivity of the heat dissipation sheet can be made still higher. From the point of view of making the thermal conductivity still higher, a clumped boron nitride particle is more preferred. The clumped boron nitride is one where primary particles of hexagonal crystal boron nitride are aggregated. The clumped boron nitride particle provides a merit of further increasing the thermal conductivity, and however, provides such a demerit that the primary particle is peeled so that the viscosity of the slurry of the thermally conductive resin composition is increased, thereby causing difficulty in producing a thin heat dissipation sheet. From such a point of view, the first inorganic filler is further preferably a clumped boron nitride particle where primary particles of hexagonal crystal boron nitride are aggregated, which has a crushing strength of 6 MPa or more. The use of such a first inorganic filler further restrains an increase in viscosity of a slurry of the thermally conductive resin composition, which is caused when part of the first inorganic filler is peeled from the first inorganic filler on preparing a slurry of the thermally conductive resin composition. In the following, the clumped boron nitride particle having a crushing strength of 6 MPa or more is simply referred to as a clumped boron nitride particle, and the clumped boron nitride particle having a crushing strength of less than 6 MPa is referred to as an aggregated boron nitride particle.

The particle size at the first maximum point attributable to the first inorganic filler is 15 pm or more. In the case where the particle size at the first maximum point attributable to the first inorganic filler is less than 15 pm, there may be some cases where it is difficult for the first inorganic filler to be highly filled in the thermally conductive resin composition, thereby resulting in a low thermal conductivity of the heat dissipation sheet prepared by using the thermally conductive resin composition. From such a viewpoint, the particle size at the first maximum point is preferably 20 pm or more, more preferably 30 pm or more, further more preferably 40 pm or more, particularly preferably 50 pm or more. Incidentally, the particle size at the first maximum point is preferably 100 pm or less. In the case where the particle size at the first maximum point is 100 pm or less, a thin heat dissipation sheet can be prepared by using the thermally conductive resin composition. From such a viewpoint, the particle size at the first maximum point is more preferably 90 pm or less, further preferably 80 pm or less.

As the first inorganic filler having the particle size described above, those commercially available may be used. In the case where the clumped boron nitride particle, which is to be used as the first inorganic filler, is produced, the particle size at the maximum point can be controlled by adjusting the average particle size of B₄C which is a raw material for the clumped boron nitride particle. When the average particle size of B₄C which is a raw material for the clumped boron nitride particle is large, the particle size at the first maximum point becomes large, and when the average particle size of B₄C is small, the particle size at the first maximum point becomes small. The wording "the particle size at the first maximum point is attributable to the first inorganic filler" means that the maximum point in the particle size distribution of the first inorganic filler appears as the first maximum point in the particle size distribution of the inorganic filler component. Due to the influence of the particle size distribution of the inorganic filler component except for the first inorganic filler, there may be some cases that the particle size at the first maximum point is a little different from the particle size at the maximum point in the particle size distribution of the first inorganic filler.

As described above, the first inorganic filler is preferably a clumped boron nitride particle which is composed of aggregated primary particles of hexagonal crystal boron nitride and has a crushing strength of 6 MPa or more. In the case where the crushing strength of the clumped boron nitride particle is less than 6 MPa, while a slurry of the thermally conductive resin composition is prepared, part of the clumped boron nitride particle is peeled from the clumped boron nitride particle to thereby increase the viscosity of the thermally conductive resin composition, and the increased viscosity may cause some cases where a thin molded article can not be prepared according to a doctor blade method. Furthermore, there may be some cases where, due to the stress applied on the clumped boron nitride particle on kneading with the resin component or pressing the thermally conductive resin composition, the clumped boron nitride particle is collapsed to thereby lower the thermal conductivity of the heat dissipation sheet. From such a viewpoint, the crushing strength of the clumped boron nitride particle is preferably 7 MPa or more, more preferably 8 MPa or more, further preferably 9 MPa or more, further more preferably 10 MPa or more, especially preferably 11 MPa or more. Incidentally, the upper limit of the crushing strength of the clumped boron nitride particle is not particularly limited, and is, for example, 30 MPa or less.

The crushing strength of the clumped boron nitride particle and the aggregated boron nitride particle can be measured according to JIS R1639-5^{:}2007. Specifically, the measurement can be performed as follows. The other components than the inorganic filler component included in the thermally conductive resin composition are removed by dissolving out the other components than the inorganic filler component included in the thermally conductive resin composition with a solvent such as toluene, xylene, or a chlorine-based hydrocarbon. Then, the particle size distribution of the remaining inorganic filler component is measured by a laser diffraction/scattering particle size distribution measuring apparatus manufactured by Beckman Coulter (LS-13 320). Next, the inorganic filler component is sprinkled on the sampling stage of a micro compression testing machine ("MCT-W500" manufactured by Shimadzu Corporation), sizes of of the inorganic filler component with respect to the X direction and the Y direction are measured and an average thereof is referred to as particle size of the inorganic filler component. Five inorganic filler components having a particle size falling within a range of the particle size at the first maximum point ± 5 pm are selected, and then subjected to the compression testing one by one. The crushing strength (σ: MPa) is calculated according to Formula σ = α•P/(π•d²) including dimensionless number (α = 2.48) which varies depending on the position inside the particle, crushing testing force (P:N), and particle size (d: pm). Based on the crushing strength of 5 inorganic filler components, Weibull plot is formed, according to JIS R1625:2010 and the crushing strength at an accumulated crushing rate of 63.2% is taken as crushing strength of the first inorganic filler. The term "accumulated crushing rate of 63.2%" is known as a value satisfying InIn[1/(1-F(t))] = 0 in Weibull distribution function as instructed in JIS R1625:2010 referred in JIS R1639-5:2007, and is a value based on the number of the particle.

The accumulated amount of the frequency between the peak start and the peak end of the peak having the first maximum point is 70% or more. When the accumulated amount is less than 70%, there may be some cases where, due to the inorganic fillers other than the first inorganic filler, the viscosity is increased so that a thin thermally conductive resin composition can not be prepared according to a doctor blade method. Furthermore, for enabling the inorganic filler component to exhibit the effect of the incorporation of the second inorganic filler described later, the above accumulated amount is preferably 90% or less, more preferably 80% or less. When the first inorganic filler having a particularly high strength and the second inorganic filler described later are used in combination, not only the manufacturability is improved, but also a heat dissipation sheet where the inorganic filler is densely packed can be provided. The accumulated amount of the frequency between the peak start and the peak end of the peak having the first maximum point is approximately the content of the first inorganic filler (% by volume) based on the inorganic filler component. Therefore, by analyzing the composition of the inorganic filler component, the inorganic filler which the first maximum point is attributable to can be determined.

Referring to Fig. 1, the accumulated amount of the frequency between the peak start and the peak end of the peak having the first maximum point is illustrated. Fig. 1 is a figure showing an example of the particle size distribution of the inorganic filler component. The axis of abscissa is logarithm. The symbol M1 indicates the first maximum point, and the symbol M2 indicates the second maximum point. PS indicates a peak start, and PE indicates a peak end. Further, as shown in Fig. 1, in the case where the bottom parts of adjacent peaks overlap, the position at the valley between the peaks is designated as the peak start (PS). The accumulated amount of the shaded portion of the peak having the first maximum point (M1) is an accumulated amount of the frequency between the peak start (PS) and the peak end (PE) of of the peak having the first maximum point (M1). In the case where the bottom part of the peak overlaps the bottom part of an adjacent peak on the peak end side, the position at the valley between the peaks is designated as the peak end.

As described above, as the first inorganic filler, the use of a clumped boron nitride particle having a high crushing strength is preferred. Here, a method of producing the clumped boron nitride particle having a high crushing strength is described below.

The clumped boron nitride particle, which is aggregated primary particles of hexagonal crystal boron nitride and has a crushing strength of 6 MPa or more, can be produced, for example, by synthesizing boron carbide, with boron and acetylene black being used as raw materials, and subjecting the obtained boron carbide to (1) pressure nitridation firing step and (2) decarbonization crystallization step. In the following, each step is described in detail.

### (1) Pressure Nitridation Firing Step

In the pressure nitridation firing step, boron carbide having an average particle size of 6 to 55 pm and a carbon content of 18 to 21% is subjected to pressure nitridation firing, whereby boron carbonitride suitable as a raw material for the clumped boron nitride particle of the present invention can be obtained.

### (i) Boron Carbide as Raw Material which is to be Used in Pressure Nitridation Step

The average particle size of boron carbide which is used as a raw material in the pressure nitridation step strongly affects the clumped boron nitride particle prepared finally, so it is necessary to select boron carbide having an appropriate particle size, and boron carbide having an average particle size of 6 to 55 pm is preferably used as a raw material. In this case, it is preferred that impurities, i.e., boron and free carbon, are less.

The average particle size of boron carbide as a raw material is preferably 6 pm or more, more preferably 7 pm or more, further preferably 10 pm or more, and preferably 55 pm or less, more preferably 50 pm or less, further preferably 45 pm or less. Incidentally, the average particle size of boron carbide, which is a raw material, is preferably from 7 to 50 pm, more preferably from 10 to 45 pm. The average particle size of boron carbide can be measured by a laser diffraction/scattering particle size distribution measuring apparatus (LS-13 320) manufactured by Beckman Coulter.

The carbon content of the boron carbide which is a raw material to be used in the pressure nitridation step is preferably less than the compositional one based on B₄C (21.7%), and the boron carbide having a carbon content of 18 to 21% is preferably used. The reasons why the carbon content of boron carbide is selected to fall within such a range are as follows. In the case where the content of carbon which generates in the decarbonization crystallization step as described later is less, a densely clumped boron nitride particle is generated and the carbon content of the finally obtained clumped boron nitride particle is lowered. Incidentally, it is difficult to prepare a stable boron carbide having the carbon content of less than 18%, since the content causes too much difference from the theoretical composition.

### (ii) Pressure Nitridation Firing

The pressure nitridation firing is performed an atmosphere having the specific firing temperature and a pressurized condition. The firing temperature in the pressure nitridation firing is preferably 1,800 to 2,200°C, and the pressure in the pressure nitridation firing is preferably 0.6 to 1.0 MPa. For the atmosphere for the pressure nitridation firing, a gas which enables the nitriding reaction to proceed is required, and for example, nitrogen gas, ammonia gas, and the like are exemplified, and these may be used singly or two or more thereof may be used in combination. Among them, nitrogen gas is suitable from the viewpoints of nitriding and being economical. The firing time in the pressure nitridation firing is preferably 6 to 30 hours.

### (2) Decarbonization Crystallization Step

In the decarbonization crystallization step, the boron carbonitride obtained by the pressure nitridation step is subjected to a heat treatment which includes: (a) under an atmosphere of ordinary pressure or more, (b) at the specific temperature-raising temperature, (c) raising the temperature until the firing temperature which falls within the specific temperature range, and (d) holding the firing temperature for the specific time. In such a manner, the clumped boron nitride particle where the primary particles (the primary particles being scaly hexagonal crystal boron nitride) are aggregated to become a clumped form can be obtained. Particularly, by adjusting the conditions of the above heat treatment to fall within the scope described later, a crushing strength of 6 MPa or more can be achieved.

In the decarbonization crystallization step, as described above, the boron carbonitride obtained from the prepared boron carbide is subjected to decarbonization, converted into scaly particles having the prescribed size, and aggregated to obtain the clumped boron nitride particle.

More specifically, the decarbonization crystallization step includes mixing 100 parts by mass of the boron carbonitride obtained by the pressure nitridation firing step, from 65 to 130 parts by mass of at least one compound of boron oxide and boron to thereby prepare a mixture, raising the temperature of the mixture to a temperature at which the decarbonization is capable of initiating, raising the temperature at a temperature-raising temperature of 5°C/min or less to a firing temperature of 1,800 °C or more, and holding the firing temperature for more than 0.5 hour to less than 40 hours.

The pressure condition of "(a) under an atmosphere of ordinary pressure or more" in the decarbonization crystallization step is preferably ordinary pressure or more, more preferably 0.1 MPa or more. Further, the upper limit of the pressure condition of the atmosphere is not particularly limited, and is preferably 1 MPa or less. The above-described "atmosphere" in the decarbonization crystallization step is preferably nitrogen gas.

The temperature-raising of "(b) at the specific temperature-raising temperature" in the decarbonization crystallization step may be performed at a single stage or multi stages. "A temperature at which the decarbonization is capable of initiating" is not particularly limited, and may be a temperature adopted generally, for example, approximately from 800 to 1,200°C (preferably about 1,000°C). "The temperature-raising at the first stage" may be performed, for example, at a range of 5 to 20°C/min, preferably 8 to 12°C/min.

The specific temperature range (firing temperature after raising temperature) in "(c) raising the temperature until the firing temperature which falls within the specific temperature range" is 1,800°C or more, further preferably may be 2,000°C or more. The upper limit of the holding temperature is not particularly limited, and is preferably 2,200°C or less, more preferably 2, 100°C or less. In the case where the holding temperature is as low as less than 1,800°C, there is a possibility that the particle growth does not occur sufficiently, so that the thermal conductivity is lowered. On the other hand, in the case where the holding temperature is 1,800°C or more, the particle growth is likely to occur favorably, thereby exhibiting an effect of easily enhancing the thermal conductivity.

The holding the firing temperature for the specific time (firing time after raising temperature) of "(d) holding the firing temperature for the specific time" is not particularly limited, as long as the crystallization proceeds sufficiently. In a preferred embodiment, for example, a range of more than 0.5 hour and less than 40 hours, more preferably a range of 1 to 30 hours may be adopted. The holding time may be preferably 1 hour or more, more preferably 3 hours or more, further preferably 5 hours or more, further more preferably 10 hours or more. The upper limit of the holding time may be preferably 30 hours or less, more preferably 20 hours or less. In the case where the holding time is 1 hour or more, it is expected that the particle growth occurs favorably, and in the case where the holding time is 30 hours or less, it is expected that lowering of the particle strength due to excessive proceeding of the particle growth can be reduced, and further, an industrial disadvantage due to the long firing time can be reduced.

Through the above pressure nitridation firing step and the above decarbonization crystallization step, the clumped boron nitride particle of the present invention can be obtained. Further, in the case where weak aggregates between particles of the clumped boron nitride particle are to be loosened, the clumped boron nitride particle obtained by the decarbonization crystallization step is subjected to pulverizing or crushing, and preferably further classifying. The pulverizing and crushing are not limited particularly, and may be performed by using a pulverizer and a crusher which are generally used. Further, for classifying, a sieving method being adopted generally for providing an average particle size of 20 pm or more may be used. For example, examples thereof include a method which includes crushing with a Henschel mixer or a mortar and subsequently classifying with a vibration sieve machine.

### <Second Inorganic Filler>

The particle size at the second maximum point attributable to the second inorganic filler is 30% or more and 2/3 or less the particle size at the first maximum point. In the case where the particle size at the second maximum point is more than 2/3 the particle size at the first maximum point, there may be some cases where the thermally conductive resin composition can not include the inorganic filler component at a high filling rate so that a thin heat dissipation sheet having an excellent thermal conductance can not be prepared. From such a viewpoint, the particle size at the second maximum point is preferably 60% or less of the particle size at the first maximum point, more preferably 55% or less of the particle size at the first maximum point, further preferably 52% or less of the particle size at the first maximum point. Further, the lower limit of the particle size at the second maximum point is, for example, 40% or more of the particle size at the first maximum point. The second maximum point can be measured in the same manner as in the measurement of the first maximum point. With respect to the second maximum point, plural second maximum points may be present. The accumulated amount of the frequency between the peak start and the peak end of the peak having the second maximum point is approximately the content of the second inorganic filler (% by volume) based on the inorganic component. Therefore, by analyzing the composition of the inorganic filler component, the inorganic filler which the second maximum point is attributable to can be determined.

The accumulated amount of the frequency between the peak start and the peak end of the peak having the second maximum point is 50% or less, may be 45% or less, may be 40% or less, and may be 35% or less. The lower limit is 25% or more.

The second inorganic filler is also not limited particularly, as long as it is an inorganic filler having a thermal conductivity higher than that of the resin component. For the second inorganic filler, alumina particles, aluminum nitride particles, boron nitride particles and the like may be exemplified. With respect to these second inorganic fillers, one may be used singly, or two or more thereof may be used in combination. Among them, the second inorganic filler is preferably boron nitride particles. Using boron nitride particles as the second inorganic filler, the thermal conductivity of the heat dissipation sheet prepared by using the thermally conductive resin composition can be made still higher. From a viewpoint of making the thermal conductivity still higher, the clumped boron nitride particle is more preferred. The clumped boron nitride is one where primary particles of hexagonal crystal boron nitride are aggregated. The clumped boron nitride particle provides a merit of further increasing the thermal conductivity, and, however, providing such a demerit that peeling of the primary particles is caused, thereby providing some difficulty in producing a thin heat dissipation sheet. From such a point of view, the second inorganic filler is also further preferably the clumped boron nitride particle which is composed of aggregated primary particles of hexagonal crystal boron nitride and has a crushing strength of 6 MPa or more. In the following, with respect to the second inorganic filler as well, the clumped boron nitride particle having a crushing strength of 6 MPa or more is simply referred to as a clumped boron nitride particle, and the clumped boron nitride particle having a crushing strength of less than 6 MPa is referred to as an aggregated boron nitride particle. Moreover, the clumped boron nitride particle for the second inorganic filler can be prepared in the same manner as in the preparation of the clumped boron nitride particle for the first inorganic filler. By adjusting the average particle size of B₄C which is a raw material for the clumped boron nitride particle, the particle size at the second maximum point attributable to the second inorganic filler can be controlled to be 2/3 or less the particle size at the first maximum point.

As for the second inorganic filler, the crushing strength of the clumped boron nitride particle or the aggregated boron nitride particle can be measured according to JIS R1639-5^{:}2007. Specifically, the crushing strength can be measured as described below. The other components than the inorganic filler component included in the thermally conductive resin composition are removed by dissolving out the other components than the inorganic filler component included in the thermally conductive resin composition with a solvent such as toluene, xylene, or a chlorine-based hydrocarbon. Then, the particle size distribution of the remaining inorganic filler component is measured by a laser diffraction/scattering particle size distribution measuring apparatus (LS-13 320) manufactured by Beckman Coulter. Next, the inorganic filler component is sprinkled on the sampling stage of a micro compression testing machine ("MCT-W500", manufactured by Shimadzu Corporation), sizes of of the inorganic filler component with respect to X direction and Y direction are measured and an average thereof is referred to as particle size of the inorganic filler component. Five inorganic filler components having a particle size falling within a range of the particle size at the second maximum point ± 5 pm are selected, and then subjected to the compression testing one by one. The crushing strength (σ: MPa) is calculated according to Formula σ = α•P/(π•d²), based on dimensionless number (α = 2.48) which varies depending on the position inside the particle, crushing testing force (P:N), and particle size (d: pm). Based on the crushing strength of the five inorganic filler components, Weibull plot is formed according to JIS R1625:2010, and the crushing strength at a cumulative breakage rate of 63.2% is taken as crushing strength of the second inorganic filler.

With respect to the particle size accumulation of the inorganic filler component, the accumulated amount of the frequency at the particle size of from 0 to 15 pm is preferably less than 60%. In this case, the content of the inorganic filler having a particle size of 15 pm or more based on the inorganic filler component is approximately 40% by volume or more, the thermally conductive resin composition can include the inorganic filler component at a high filling rate, thereby making the thermal conductivity of the heat dissipation sheet prepared by using the thermally conductive resin composition still higher. From such a viewpoint, with respect to the particle size accumulation of the inorganic filler component, the accumulated amount of the frequency at the particle size of from 0 to 15 pm is more preferably less than 50%, further preferably less than 40%, further more preferably less than 30%.

### (Resin Component)

Examples of the resin for the resin component include an epoxy resin, a silicone resin (including a silicone rubber), an acrylic resin, a phenol resin, a melamine resin, a urea resin, an unsaturated polyester, a fluorine resin, a polyamide (for example, polyimide, polyamideimide, polyetherimide, etc.), a polyester (for example, polybutylene terephthalate, polyethylene terephthalate, etc.), polyphenylene ether, polyphenylene sulfide, a fully aromatic polyester, polysulfone, a liquid crystal polymer, polyether sulfone, polycarbonate, a maleimide-modified resin, an ABS resin, an AAS (acrylonitrile•acrylic rubber•styrene) resin, and an AES (acrylonitrile •ethylene •propyrene•diene rubber•styrene) resin. Among them, from a viewpoint of the heat resistance, the flexibility, and the adhesiveness to a heat sink or the like, a silicone resin is preferred. Preferred example of the silicone resin includes a silicone resin capable of hardening by vulcanization with an organic peroxide. The viscosity at 25°C of the thermally conductive resin composition is, for example, 100,000 cp or more from a viewpoint of improving the flexibility of the sheet-shaped molded article.

The content of the inorganic filler component based on 100% by volume of the total amount of the inorganic filler component and the resin component is preferably from 30 to 85% by volume, more preferably from 40 to 80% by volume. In the case where the content of the inorganic filler is 30% or more, the thermal conductivity is enhanced and sufficient heat dissipation performance is easily exhibited. In the case where the content of the inorganic filler is 85% or less, liability to generation of voids on molding can be reduced and lowering in electric insulation and mechanical strength can be reduced. The content of the resin component based on 100% by volume of the thermally conductive resin composition is preferably 15 to 70% by volume, more preferably 20 to 60% by volume.

### (Solvent)

For adjusting the viscosity of the thermally conductive resin composition, the thermally conductive resin composition may further include a solvent. The solvent is not limited particularly as long as the solvent is capable of dissolving the resin component and being easily removed from the thermally conductive resin composition applied after application of the thermally conductive resin composition. In the case where the resin component is a silicone resin, as the solvent, for example, toluene, xylene, a chlorine-based hydrocarbon may be exemplified. Among them, toluene is preferred from a viewpoint of easy removal. The content of the solvent may be selected appropriately according to the viscosity of the thermally conductive resin composition to be desired. The content of the solvent is, for example, from 40 to 200 parts by mass per 100 parts by mass of the other components than the solvent included in the thermally conductive resin composition.

The thermally conductive resin composition may include the other component than the inorganic filler component, the resin component, and the solvent. Examples of the other component include additives, impurities, and the like. The content of the other component is preferably 5 parts by mass or less, more preferably 3 parts by mass or less, further preferably 1 part by mass or less, per 100 parts by mass of the total amount of the inorganic filler component and the resin component.

### [Heat Dissipation Sheet]

As described above, the heat dissipation sheet of the present invention is one prepared by molding the above-described thermally conductive resin composition. Using the thermally conductive resin composition of the present invention, a thin heat dissipation sheet can be easily prepared according to a doctor blade method. The thickness of the heat dissipation sheet of the present invention is 0.20 mm or less. The heat dissipation sheet having a thickness of 0.20 mm or less is able to meet a requirement on the thickness of the heat dissipation sheet in association with the miniaturization of heat-generating electronic parts. The thickness of the heat dissipation sheet is more preferably 0.15 mm or less, further preferably 0.12 mm or less, further more preferably 0.10 mm or less from such a view point.

Further, the surface roughness of the heat dissipation sheet of the present invention is from 1.5 to 3.0 pm. While the combination of the first inorganic filler and the second inorganic filler is adopted, the inorganic filler component is filled sufficiently such that the surface roughness becomes 1.5 pm or more, whereby sufficient thermal conductance can be achieved in spite of a thin heat dissipation sheet. This appears to be because the combined use of the specific inorganic fillers enables a high filling amount and provides a filling form where heat easily transmits. When the surface roughness of the heat dissipation is less than 1.5 pm, there may be some cases where the thermal conductance is lowered. This appears to be because the proportion of the inorganic filler component in the thermally conductive resin composition is lowered or the special filling form described above is not formed. In the case where the proportion of the inorganic filler component in the thermally conductive resin composition is low, the inorganic filler component is embedded in the resin component, so that the surface of the heat dissipation sheet becomes too smooth. On the other hand, when the surface roughness of the heat dissipation is more than 3.0 pm, there may be some cases where the thermal conductance is lowered. This appears to be because the inorganic filler component is not at a sufficiently dense packing state and the filling rate is not high, thereby failing to achieving the above-described filling form, so that the thermal conductance is not heightened. The surface roughness of the heat dissipation sheet is an arithmetic average roughness Ra, the arithmetic average roughness Ra is measured according to the descriptions in JIS B 0601:2013: "Geometrical Product Specifications (GPS) - Surface texture: Profile method - Terms, definitions and surface texture parameters".

The heat dissipation sheet preferably includes a base material having a thickness of 0.05 mm or less. In this case, the breakage of heat dissipation sheet on handling of the heat dissipation sheet can be restrained, while a thin heat dissipation sheet can be prepared. The base material is not limited particularly as long as the base material can hold the thermally conductive resin composition layer, and has an appropriate strength, a thickness of 0.05 mm or less, and flexibility. For the base material, for example, paper, cloth, film, nonwoven fabric, and metallic foil may be exemplified. Among them, from the viewpoints of favorite adhesiveness to the thermally conductive resin composition layer and the capability of restraining the inhibition to the thermal conductance of the thermally conductive resin composition, which is caused by the base material, by being provided with an aperture, cloth is preferred, and from a viewpoint of retaining the strength to some degree even when the base material is thin and is provided with a large aperture, glass cloth and polyamide-imide fiber cloth are more preferred, and glass cloth is further preferred. From a viewpoint of making the heat dissipation sheet thin, the thickness of the base material is more preferably 0.03 mm or less. From a viewpoint of the strength of the base material, the thickness of the base material is preferably 0.005 mm or more. In the case where the base material is glass cloth, the glass cloth may be subjected to a silane coupling treatment for restraining the generation of a gap between the thermally conductive resin composition and glass cloth.

The heat dissipation sheet can be prepared according to a doctor blade method. For example, the heat dissipation sheet can be prepared as follows. The inorganic filler component, the resin component and the like, which are the raw materials other than the solvent, are dispersed in the solvent to thereby prepare a slurry-like thermally conductive resin composition. In the following, the slurry-like thermally conductive resin composition is sometimes simply referred to as "slurry". The clumped boron nitride particle, which is used as the first inorganic filler, has a crushing strength of as high as 6 MPa, and therefore, on dispersing the raw materials other than the solvent in the solvent, primary particles of hexagonal crystal boron nitride are hardly peeled from the clumped boron nitride particle. As a result, on dispersing the raw materials other than the solvent in the solvent, an increase in the viscosity of the slurry can be restrained. The viscosity of the slurry may be lowered by increasing the amount of the solvent. However, in this case, on molding the thermally conductive resin composition into a sheet-shape, the thermally conductive resin composition causes foaming, and on removing the solvent from a molded article molded into a sheet-shape, the additives such as a vulcanizing agent, a curing agent and the like, in the thermally conductive resin composition may be deactivated. Accordingly, it is desired to lower the viscosity of the slurry without increasing the amount of the solvent. Since the average particle size of the clumped boron nitride particle, which is used as the first inorganic filler, is comparably large, namely, about 15 pm or more, after dispersing the raw materials of the thermally conductive resin composition other than the solvent in the solvent, aggregation of the dispersed inorganic filler component, which makes the slurry heterogeneous, can be restrained. In the case where the average particle size of the inorganic filler is too small, there may be some cases where the dispersed inorganic filler component is aggregated to thereby make the slurry heterogeneous.

The prepared slurry is supplied to a doctor blade apparatus. In the doctor blade apparatus, a slurry flows out of a clearance between the blade and the carrier film, so that the thermally conductive resin composition is molded into a sheet. In addition, the thickness of the molded article can be controlled accurately by adjusting the dimension between the blade and the carrier film and the moving velocity of the carrier film. In order to control the pressure of the slurry more accurately, thereby controlling the thickness of the molded article more accurately, a doctor blade apparatus including 2 sheets of blade may be used.

The slurry, which has flowed out of the clearance between the blade and the carrier film, moves, along with the carrier film, in the doctor blade apparatus, and while moving, is dried and solidified, thereby becoming a sheet-shaped molded article. The obtained sheet-shaped molded article is, for example, pressurized and heated to be cured, thereby becoming a heat dissipation sheet. In order to easily peel the heat dissipation sheet from the carrier film, a releasing agent may be applied on the surface of the carrier film. For the releasing agent, for example, a silicone-based releasing agent, an alkyl pendant-based releasing agent, and a condensation wax-based releasing agent and the like are exemplified.

In the case where the heat dissipation sheet includes a base material, the heat dissipation sheet is prepared as described below, for example. The base material is sandwiched with two sheets of the sheet-shaped molded articles each provided with a carrier film, which are obtained by a doctor blade method, thereby obtaining a laminate. In this case, the layer structure of the laminate is carrier film/thermally conductive resin composition/base material/thermally conductive resin composition/carrier film. Then, the laminate is pressurized and heated, and the carrier films are peeled, thereby providing a heat dissipation sheet. Also in this case, for easily peeling the heat dissipation sheet from the carrier film, a releasing agent may be applied on the surface of the carrier film.

The heat dissipation sheet may be still prepared by a calender processing. However, when the sheet-shaped thermally conductive resin composition passes through the calender rolls, there is a possibility that part of the clumped boron nitride particle is peeled from the clumped boron nitride particle in the thermally conductive resin composition. Therefore, the heat dissipation sheet is preferably prepared by a doctor blade method.

### Examples

In the following, the present invention is illustrated in detail, referring to Examples and Comparative Examples. The present invention is not limited to Examples described below.

The thermally conductive resin compositions of Examples and Comparative Examples were subjected to the following evaluations.

### (Viscosity of Slurry)

With respect to the viscosity of each slurry in preparing the heat dissipation sheets of Examples and Comparative Examples, the viscosity after being allowed to stand for 30 seconds was measured at a rotation rate of 20 rpm by means of a B-type viscometer.

### (Particle Size Distribution)

The other components than the inorganic filler component included in the thermally conductive resin composition were removed by dissolving out the other components than the inorganic filler component included in the thermally conductive resin composition with toluene. Next, the particle size distribution of the remaining inorganic filler component was measured by a laser diffraction/scattering particle size distribution measuring apparatus manufactured by Beckman Coulter (LS-13 320). From the obtained particle size distribution, the first maximum value, the second maximum value, and the accumulated amount of the frequency between the peak start and the peak end of the peak having the first maximum point were obtained.

### (Crushing Strength)

The crushing strength of the clumped boron nitride particle or the aggregated boron nitride particle was measured according to JIS R1639-5^{:}2007. The other components than the inorganic filler component included in the thermally conductive resin composition were removed by dissolving out the other components than the inorganic filler component included in the thermally conductive resin composition with a solvent such as toluene, xylene, or a chlorine-based hydrocarbon. Then, the particle size distribution of the remaining inorganic filler component was measured by a laser diffraction/scattering particle size distribution measuring apparatus (LS-13 320) manufactured by Beckman Coulter. Next, the inorganic filler component was sprinkled on the sampling stage of a micro compression testing machine ("MCT-W500", manufactured by Shimadzu Corporation), sizes of of the inorganic filler component with respect to X direction and Y direction were measured and an average thereof was referred to as particle size of the inorganic filler component. Five inorganic filler components having a particle size falling within a range of the particle size at the first maximum point ± 5 pm were selected, and then subjected to the compression testing one by one. The crushing strength (σ: MPa) is calculated according to Formula σ = α•P/(π•d²), based on dimensionless number (α = 2.48) which varies depending on the position inside the particle, crushing testing force (P:N), and particle size (d: pm). Based on the crushing strength of the five inorganic filler components, Weibull plot is formed according to JIS R1625:2010, and the crushing strength at a cumulative breakage rate of 63.2% is taken as crushing strength of the first inorganic filler. In the same manner, the crushing strength of the second inorganic filler was measured.

### (Accumulated Amount of Frequency at Particle Size of from 0 to 15 pm)

The other components than the inorganic filler component were removed from the heat dissipation sheet by dissolving out the other components than the inorganic filler component, which were included in the thermally conductive resin composition, with toluene. Next, the particle size accumulation of the remaining inorganic filler component was measured by a laser diffraction/scattering particle size distribution measuring apparatus manufactured by Beckman Coulter (LS-13 320). From the obtained particle size accumulation, the accumulated amount of the frequency at the particle size of from 0 to 15 pm was obtained.

The heat dissipation sheets of Examples and Comparative Examples were subjected to the following evaluations.

### (Heat Resistance)

The heat resistance of each heat dissipation sheet was measured under a load of 1 MPa according to ASTM D5470.

### (Relative Density)

The relative density was calculated by dividing the density of each heat dissipation sheet by the theorical density according to the Archimedes method.

### (Surface Roughness Ra)

The surface roughness of each heat dissipation sheet is an arithmetic average roughness Ra, and was measured according to JIS B 0601:2013.

### [Example 1]

In Example 1, the clumped boron nitride particle was prepared through the boron carbide synthesis, the pressure nitridation firing step, and the decarbonization crystallization step as described below.

### (Boron Carbide Synthesis)

100 parts by mass of orthoboric acid manufactured by Nippon Denko Co., Ltd. (hereinafter referred to as boric acid) and 35 parts by mass of acetylene black (HS100) manufactured by Denka Company limited were mixed in a Henschel mixer, and then charged in a graphite crucible, and the crucible was heated in an arc furnace under an argon atmosphere at 2,200°C for 5 hours, thereby synthesizing boron carbide (B₄C). The bulk of boron carbide synthesized was pulverized in a ball mill for 1 hour, sieved with a screen to obtain a boron carbide having a particle size of 75 pm or less, and the obtained boron carbide was washed with a nitric acid aqueous solution to remove the impurities such as iron, followed by filtration and drying. Thus, a boron carbide powder having an average particle size of 20 pm was prepared. The obtained boron carbide powder had a carbon content of 20.0%.

### (Pressure nitridation Step)

The synthesized boron carbide was charged in the boron nitride crucible, the crucible was heated in a resistance heating furnace under a nitrogen gas atmosphere, at 2,000°C, and under a pressure of 9 atmospheres (0.8 MPa) for 10 hours, thereby obtaining boron carbonitride (B₄CN₄).

### (Decarbonization Crystallization Step)

100 parts by mass of the synthesized boron carbonitride and 90 parts by mass of boric acid were mixed in a Henschel mixer, and then charged in a boron nitride crucible, and the crucible was heated in a resistance heating furnace at a pressure condition of 0.2 MPa, under a nitrogen gas atmosphere at a temperature-raising rate of 10°C/min in the range of room temperature to 1,000°C and at a temperature-raising rate of 2°C/min in the range of more than 1,000°C, and at a calcining temperature of 2,020°C for a holding time of 10 hours, thereby synthesizing a clumped boron nitride particle in which the primary particles were aggregated to become clump-like. The clumped boron carbonitride synthesized was crushed in a Henschel mixer for 15 minutes, and then, using a sieve, classified with a nylon screen having a mesh of 150 pm. The fired product was crushed and classified, thereby obtaining a clumped boron nitride particle 1 in which the primary particles were aggregated to become clump-like.

The average particle size (D50) of the clumped boron nitride particle 1 obtained, which was measured by a laser scattering method, was 40 pm. Further, the crushing strength of the clumped boron nitride particle 1 was 12 MPa.

### (Preparation of Heat Dissipation Sheet)

To 100% by volume of the total amount of the clumped boron nitride particle 1 obtained, the aggregated boron nitride particle (manufactured by Denka Company limited, trade name: "SGPS", average particle size: 20 pm, crushing strength: 1.5 MPa), a scaly boron nitride particle (manufactured by Denka Company limited, trade name: "SP-3-7", average particle size: 3 pm), and a liquid silicone resin 1 (methylvinyl polysiloxane, manufactured by Dow Toray Co., Ltd., trade name: "CF-3110"), 45% by volume of the clumped boron nitride particle 1, 12% by volume of the aggregated boron nitride particle, 3% by volume of the scaly boron nitride particle, 40% by volume of silicone resin 1, 1 part by mass of a curing agent (2,5-dimethyl-2,5-bis(t-butylperoxy)hexane, manufactured by Kayaku Nouryon Corporation, trade name: "Trigonox 101") per 100 parts by mass of the silicone resin, 0.5 % by mass of a silane coupling agent (dimethyldimethoxysilane, manufactured by Dow Toray Co., Ltd., trade name: "Dowsil Z-6329 Silane", viscosity at 25°C: 1 cp) per 100 parts by mass of the total amount of the clumped boron nitride particle, the aggregated boron nitride particle and the scaly boron nitride particle, 15 parts by mass of water per 100 parts by mass of the silane coupling agent, and 110 parts by mass of toluene per 100 parts by mass of the total amount of the raw materials described above were charged in a mixer (manufactured by Heidon (Shinto Scientic Co., Ltd.), trade name: "Three-One Motor"), and mixed therein with a turbine type stirring blade for 15 hours, thereby preparing a slurry of the thermally conductive resin composition. The viscosity of the slurry was 10,000 cp.

Then, the above slurry was applied on a PET film (carrier film) having a thickness of 0.05 mm according to a doctor blade method such that the applied slurry had a thickness of 0.2 mm, and dried at 75°C for 5 minutes, thereby preparing a sheet-shaped molded article with a PET film. Glass cloth (thickness: 0.025 mm) was sandwiched between two sheets of the sheet-shaped molded article with a PET film such that the surfaces applied with the thermally conductive resin composition contact both surfaces of the glass cloth, respectively, thereby preparing a laminate. The layer structure of the laminate was PET film/thermally conductive resin composition/glass cloth/thermally conductive resin composition/PET film. Next, the obtained laminate was subjected to hot pressing for 25 minutes under the conditions of a temperature of 150°C and a pressure of 160 kg/cm², and then, the PET films were peeled to provide a sheet having a thickness of 0.09 mm. Subsequently, the sheet was subjected to the second heating at ordinary pressure and at 150°C for 4 hours, and the resulting sheet was designated as a heat dissipation sheet of Example 1.

### [Example 2]

A heat dissipation sheet of Example 2 was prepared in the same manner as in Example 1 except that the blended amount of toluene was changed from 110 parts by mass to 60 parts by mass and a heat dissipation sheet having a thickness of 0.20 mm was prepared by changing the coating application condition of the doctor blade method. The slurry had a viscosity of 7,000 cp.

### [Example 3]

A heat dissipation sheet of Example 3 was prepared in the same manner as in Example 1 except that: 42% by volume of a clumped boron nitride particle 2 having an average particle size of 75 pm and a crushing strength of 12 MPa was blended instead of 45% by volume of the clumped boron nitride particle 1 having an average particle size of 40 pm and a crushing strength of 12 MPa; 11% by volume of a clumped boron nitride particle 3 having an average particle size of 38 pm and a crushing strength of 12 MPa was blended instead of 12% by volume of the aggregated boron nitride particle; the scaly boron nitride particle was not blended; the blended amount of the silicone resin 1 was changed from 40% by volume to 47% by volume; the blended amount of toluene was changed from 110 parts by mass to 100 parts by mass; and a heat dissipation sheet having a thickness of 0.10 mm was prepared by changing the coating application condition of the doctor blade method. The clumped boron nitride particles 2 and 3 used for the heat dissipation sheet of Example 3 were prepared in the same manner as in the preparation of the clumped boron nitride particle 1 which was used for the heat dissipation sheet of Example 1 except for changing the time of pulverizing the synthesized bulk of boron carbide by a ball mill, thereby changing the average particle size of the boron carbide powder. The viscosity of the slurry was 10,000 cp.

### [Example 4]

A heat dissipation sheet of Example 4 was prepared in the same manner as in Example 3 except that a heat dissipation sheet having a thickness of 0.20 mm was prepared by changing the coating application condition of the doctor blade method.

### [Example 5]

A heat dissipation sheet of Example 5 was prepared in the same manner as in Example 1 except that a clumped boron nitride particle 4 having an average particle size of 55 pm and a crushing strength of 10 MPa was blended instead of the clumped boron nitride particle 2 and a heat dissipation sheet having a thickness of 0.10 mm was prepared by changing the coating application condition of the doctor blade method. The clumped boron nitride particle 4 which was used for the heat dissipation sheet of Example 5 was prepared in the same manner as in the preparation of the clumped boron nitride particles 1 which was used for the heat dissipation sheet of Example 1 except for changing the time of pulverizing the synthesized bulk of boron carbide by a ball mill, thereby changing the average particle size of the boron carbide powder. The viscosity of the slurry was 9,500 cp.

### [Example 6]

A heat dissipation sheet of Example 6 was prepared in the same manner as in Example 5 except that a heat dissipation sheet having a thickness of 0.20 mm was prepared by changing the coating application condition of the doctor blade method.

### [Comparative Example 1]

A heat dissipation sheet of Comparative Example 1 was prepared in the same manner as in Example 1 except that the clumped boron nitride particle 1 and the scaly boron nitride particle were not blended; the blended amount of the aggregated boron nitride particle was changed from 12% by volume to 60% by volume; the blended amount of the silane coupling agent was changed from 0.5 parts by mass to 0.2 parts by mass; and a heat dissipation sheet having a thickness of 0.20 mm was prepared by changing the coating application condition of the doctor blade method. The viscosity of the slurry was 12,000 cp. Because of the high viscosity of the slurry, a heat dissipation sheet having a thickness of 0.15 mm or less could not be prepared.

### [Comparative Example 2]

A heat dissipation sheet of Comparative Example 2 was prepared in the same manner as in Comparative Example 1 except that a heat dissipation sheet having a thickness of 0.30 mm was prepared by changing the coating application condition of the doctor blade method.

### [Comparative Example 3]

A slurry was prepared in the same manner as in Example 5 except for changing the clumped boron nitride particle 3 to the clumped boron nitride particle 1. The viscosity of the slurry was as high as 16,000 cp, so that a heat dissipation sheet having a thickness of 0.20 mm could not be prepared.

### [Comparative Example 4]

A slurry was prepared in the same manner as in Example 1 except for changing the blended amount of the clumped boron nitride particle 1 from 45% by volume to 12% by volume and the blended amount of the aggregated boron nitride particle from 12% by volume to 45% by volume. The viscosity of the slurry was as high as 18,000 cp, so that a heat dissipation sheet having a thickness of 0.20 mm could not be prepared.

The evaluation results of the heat dissipation sheets of Examples 1 to 6 and Comparative Examples 1 to 4 are shown in Table 1.

**Table 1**

| | | | | Example 1 | Example 2 | Example 3 | Example 4 | Example 5 | Example 6 | Comparative Example 1 | Comparative Example 2 | Comparative Example 3 | Comparative Example 4 |
|---|---|---|---|---|---|---|---|---|---|---|---|---|---|
| | Inorganic Filler Component | Clumped Boron Nitride Particle 1 | % by vol. | 45 | 45 | - | - | - | - | - | - | 11 | 12 |
| | | Clumped Boron Nitride Particle 2 | % by vol. | - | - | 42 | 42 | - | - | - | - | - | - |
| | | Clumped Boron Nitride Particle 3 | % by vol. | - | - | 11 | 11 | 11 | 11 | - | - | - | - |
| | | Clumped Boron Nitride Particle 4 | % by vol. | - | - | - | - | 42 | 42 | - | - | 42 | - |
| | | Aggregated Boron Nitride Particle | % by vol. | 12 | 12 | - | - | - | - | 60 | 60 | - | 45 |
| Formulation | | Sclay Boron Nitride Particle | % by vol. | 3 | 3 | - | - | - | - | - | - | - | 3 |
| | Resin Component | Silicone Resin 1 | % by vol. | 40 | 40 | 47 | 47 | 47 | 47 | 40 | 40 | 47 | 40 |
| | | Silicone Resin 2 | % by vol. | - | - | - | - | - | - | - | - | - | - |
| | Curing Agent *1 | | parts by mass. | 1 | 1 | 1 | 1 | 1 | 1 | 1 | 1 | 1 | 1 |
| | Silane Coupling Agent *2 | | parts by mass | 0.5 | 0.5 | 0.5 | 0.5 | 0.5 | 0.5 | 0.2 | 0.2 | 0.2 | 0.5 |
| | Water *3 | | parts by mass | 15 | 15 | 15 | 15 | 15 | 15 | 15 | 15 | 15 | 15 |
| | Toluene *4 | | parts by mass | 110 | 60 | 100 | 100 | 100 | 100 | 100 | 100 | 100 | 110 |
| Evaluation of Slurry | Viscosity of Slurry | | cp | 10,000 | 7,000 | 10,000 | 10,000 | 9,500 | 9,500 | 12,000 | 12,000 | 16,000 | 18,000 |
| Thickness of Glass Cloth | | | mm | 0.025 | 0.025 | 0.025 | 0.025 | 0.025 | 0.025 | 0.05 | 0.05 | *5 | *5 |
| Evaluation of Heat Dissipation Sheet | Particle Size at First Maximum Value | | µm | 40 | 40 | 75 | 75 | 55 | 55 | 20 | 20 | | |
| | Crushing Strength of First Inorganic Filler | | MPa | 12 | 12 | 12 | 12 | 7 | 7 | 1.5 | 1.5 | | |
| | Accumulated Amount of Frequency of Peak Having First Maximum Point | | % | 75 | 75 | 79 | 79 | 79 | 79 | 100 | 100 | | |
| | Particle Size at Second Maximum Point | | µm | 20 | 20 | 35 | 35 | 35 | 35 | - | - | | |
| | Crushing Strength of Second Inorganic Filler | | MPa | 1.5 | 1.5 | 12 | 12 | 12 | 12 | - | - | | |
| | Accumulated Amount of Frequency at Particle Size of from 0 to 15 µm | | % | 25 | 17 | 8 | 7 | 9 | 10 | 76 | 82 | | |
| | Thickness | | mm | 0.09 | 0.20 | 0.10 | 0.20 | 0.10 | 0.20 | 0.20 | 0.30 | | |
| | Heat Resistance | | k/W | 0.45 | 0.51 | 0.42 | 0.60 | 0.36 | 0.48 | 1.0 | 1.2 | | |
| | Relative Density | | % | 91 | 90 | 97 | 94 | 93 | 94 | 90 | 90 | | |
| | Surface Roughness Ra | | µm | 2.0 | 1.6 | 2.9 | 2.7 | 2.1 | 1.8 | 3.1 | 1.4 | | |

| | | | | | | | | | | | | | |
|---|---|---|---|---|---|---|---|---|---|---|---|---|---|
| *1 Blended amount per 100 parts by mass of the silicone resin *2 Blended amount per 100 parts by mass of the total amount of the clumped boron nitride particle, the aggregated boron nitride particle and the sclay boron nitride particle *3 Blended amount per 100 parts by mass of the silane coupling agent *4 Blended amount per 100 parts by mass of the total amount of the raw materials except for toluene *5 A heat dissipation sheet having a thickness of 0.20 mm could not appropriately molded. | | | | | | | | | | | | | |

From the evaluation results of the heat dissipation sheets of Examples 1 to 6, it can be seen that a thin heat dissipation sheet having excellent thermal conductance can be obtained in the cases where the particle size distribution of the inorganic filler component includes a first maximum point attributable to the first inorganic filler and a second maximum point attributable to the second inorganic filler, the particle size at the first maximum point is 15 pm or more, the particle size at the second maximum point is 2/3 or less the particle size at the first maximum point, the accumulated amount of the frequency between the peak start and the peak end of the peak having the first maximum point is 50% or more, the surface roughness of the heat dissipation sheet is from 1.5 to 3.0 pm, and the thickness of the heat dissipation sheet is 0.2 mm or less.

From the evaluation results of the heat dissipation sheets of Comparative Examples 1 and 2, it can be seen that unless the second inorganic filler is included, the thermally conductive characteristics are inferior, and unless the second inorganic filler is included, a thin heat dissipation sheet having a thickness of 0.15 mm or less cannot be prepared.

In Comparative Example 3, a heat dissipation sheet could not be prepared. Based on the formulation of the thermally conductive resin composition, it appears that the particle size at the second maximum point is more than 2/3 the particle size at the first maximum point.

In Comparative Example 4, a heat dissipation sheet could not be prepared. Based on the formulation of the thermally conductive resin composition, it appears that the accumulated amount of the frequency between the peak start and the peak end of the peak having the first maximum point is less than 50%.

### [Example 7]

A heat dissipation sheet having a thickness of 0.2 mm was prepared in the same manner as in Example 4 except for changing the silicone resin CF3110 to an epoxy resin (a bisphenol type epoxy resin manufactured by Mitsubishi Chemical Corporation, model number: JER-807), changing a curing agent Trigonox 101 (1 part by mass) to a curing agent MEH-8005 (manufactured by Meiwa Plastic Industries, Ltd., 10 parts by mass), and adding 2PHZ-PW (manufactured by Shikoku Chemicals Corporation, 1 part by mass) as a curing accelerator, and the heat resistance was measured according to the above-described method. The surface roughness was 2.6 pm.

### [Comparative Example 5]

A heat dissipation sheet having a thickness of 0.2 mm was prepared in the same manner as in Comparative Example 1 except for changing the silicone resin CF3110 to an epoxy resin (a bisphenol type epoxy resin manufactured by Mitsubishi Chemical Corporation, model number: JER-807), changing a curing agent Trigonox 101 (1 part by mass) to a curing agent MEH-8005 (manufactured by Meiwa Plastic Industries, Ltd., 10 parts by mass), and adding 2PHZ-PW (manufactured by Shikoku Chemicals Corporation, 1 part by mass) as a curing accelerator, and the heat resistance was measured according to the above-described method. The surface roughness was 3.2 pm.

Comparing the heat resistance of Example 7 and the heat resistance of Comparative Example 5, Example 7 exhibited the lower heat resistance, and provided a favorite result. Therefore, the effect exhibited by combining the specific inorganic fillers was exhibited not depending on the kinds of the resin.

## Claims

1. A heat dissipation sheet,
which is prepared by molding a thermally conductive resin composition prepared by blending an inorganic filler component and a resin component, the inorganic filler component including a first inorganic filler and a second inorganic filler,
provided that particle size distribution of the inorganic filler component includes a first maximum point attributable to the first inorganic filler and a second maximum point attributable to the second inorganic filler;
the particle size at the first maximum point is 15 µm or more;
the particle size at the second maximum point is 30% or more and 2/3 or less the particle size at the first maximum point; and
an accumulated amount of the frequency between the peak start and the peak end of the peak having the first maximum point is 70% or more,
an accumulated amount of the frequency between the peak start and the peak end of the peak having the second maximum point is 25% or more; and
which has a surface roughness of from 1.5 to 3.0 pm and a thickness of 0.2 mm or less.

2. The heat dissipation sheet according to claim 1,
wherein, with respect to the particle size accumulation of the inorganic filler component, the accumulated amount of the frequency at the particle size of from 0 to 15 µm is less than 60%.

3. The heat dissipation sheet according to claim 1 or 2, further comprising a base material having a thickness of 0.05 mm or less.

## Patentansprüche

1. Wärmeableitungsfolie,
hergestellt durch Formen einer wärmeleitenden Harzzusammensetzung, die durch Mischen einer anorganische Füllstoffkomponente und einer Harzkomponente hergestellt wird, wobei die anorganische Füllstoffkomponente einen ersten anorganischen Füllstoff und einen zweiten anorganischen Füllstoff umfasst,
mit der Maßgabe, dass die Partikelgrößenverteilung der anorganischen Füllstoffkomponente einen ersten Maximalpunkt, der dem ersten anorganischen Füllstoff zuzuschreiben ist, und einen zweiten Maximalpunkt, der dem zweiten anorganischen Füllstoff zuzuschreiben ist, umfasst;
die Partikelgröße an dem ersten Maximalpunkt 15 µm oder mehr beträgt;
die Partikelgröße an dem zweiten Maximalpunkt 30 % oder mehr und 2/3 oder weniger der Partikelgröße an dem ersten Maximalpunkt beträgt; und
ein akkumuliertes Maß der Häufigkeit zwischen dem Peak-Beginn und dem Peak-Ende des Peaks mit dem ersten Maximalpunkt 70 % oder mehr beträgt,
ein akkumuliertes Maß der Häufigkeit zwischen dem Peak-Beginn und dem Peak-Ende des Peaks mit dem zweiten Maximalpunkt 25 % oder mehr beträgt; und
die eine Oberflächenrauheit von 1,5 bis 3,0 µm und eine Dicke von 0,2 mm oder weniger aufweist.

2. Wärmeableitungsfolie nach Anspruch 1,
wobei in Bezug auf die Partikelgrößenakkumulation der anorganischen Füllstoffkomponente das akkumulierte Maß der Häufigkeit bei der Partikelgröße von 0 bis 15 µm weniger als 60 % beträgt.

3. Wärmeableitungsfolie nach Anspruch 1 oder 2, die ferner ein Basismaterial mit einer Dicke von 0,05 mm oder weniger umfasst.

## Revendications

1. Feuille de dissipation de chaleur,
préparée par moulage d'une composition de résine thermoconductrice préparée par mélange d'un composant de charge inorganique et d'un composant de résine, le composant de charge inorganique comprenant une première charge inorganique et une seconde charge inorganique,
à condition que la distribution de la taille des particules du composant de charge inorganique comprenne un premier point maximal attribuable à la première charge inorganique et un second point maximal attribuable à la seconde charge inorganique ;
la taille des particules au premier point maximal est égale ou supérieure à 15 µm ;
la taille des particules au second point maximal est supérieure ou égale à 30 % et inférieure ou égale à 2/3 de la taille des particules au premier point maximal ; et
une quantité accumulée de la fréquence entre le début et la fin du pic ayant le premier point maximal est de 70 % ou plus,
une quantité accumulée de la fréquence entre le début et la fin du pic ayant le second point maximal est supérieure ou égale à 25 % ; et
ayant une rugosité de surface de 1,5 à 3,0 µm et une épaisseur qui est inférieure ou égale à 0,2 mm.

2. Feuille de dissipation de chaleur selon la revendication 1,
dans laquelle, au regard de l'accumulation de la taille des particules du composant de charge inorganique, la quantité accumulée de la fréquence à la taille des particules de 0 à 15 pm est inférieure à 60 %.

3. Feuille de dissipation de chaleur selon la revendication 1 ou 2, comprenant en outre un matériau de base d'une épaisseur de 0,05 mm ou moins.
